(19) Europäisches Patentamt
European Patent Office
Office européen des brevets

(11) **EP 1 439 589 A2**

(12) **EUROPEAN PATENT APPLICATION**

(43) Date of publication:
**21.07.2004 Bulletin 2004/30**

(51) Int Cl.⁷: **H01L 51/20**

(21) Application number: **04075035.8**

(22) Date of filing: **07.01.2004**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **17.01.2003 US 346424**

(71) Applicant: **EASTMAN KODAK COMPANY
Rochester, New York 14650 (US)**

(72) Inventors:
• **Tyan, Yuan-Sheng
Rochester New York 14650-2201 (US)**

• **Shore, Joel D.
Rochester New York 14650-2201 (US)**
• **Farruggia, Giuseppe
Rochester New York 14650-2201 (US)**
• **Raychaudhuri, Pranab K.
Rochester New York 14650-2201 (US)**
• **Madathil, Joseph K.
Rochester New York 14650-2201 (US)**

(74) Representative: **Weber, Etienne Nicolas
Kodak Industrie,
Département Brevets,
CRT,
Zone Industrielle
71102 Chalon sur Saône Cedex (FR)**

(54) **Microcavity oled devices**

(57)     A microcavity OLED device including a substrate; a metallic bottom-electrode layer disposed over one surface of the substrate; an organic EL element disposed over the metallic bottom-electrode layer; and a metallic top-electrode layer disposed over the organic EL element, one of the metallic electrode layers is semitransparent and the other one is essentially opaque and reflective; and one of the metallic electrode layers is semitransparent and the other one is essentially opaque and reflective; and wherein the materials for the opaque and reflective metallic electrode layer are selected from Ag, Au, Al, or alloys thereof, the materials for the semitransparent metallic electrode layer are selected from Ag, Au, or alloys thereof, and the thickness of the semitransparent metallic electrode layer and the location of the light emitting layer are selected to enhance the emission output of the microcavity OLED device above that of a similar device without the microcavity.

FIG. 3a

**Description**

The present invention relates to organic light-emitting diodes (OLEDs) having microcavity effects.

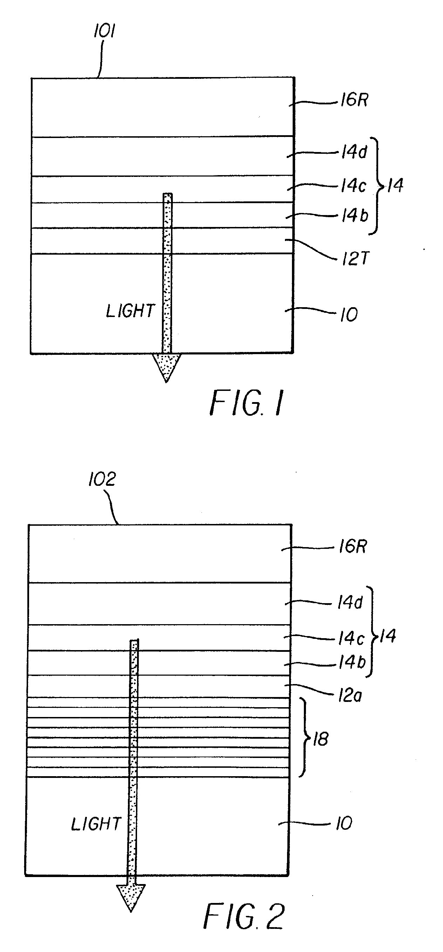

Organic electroluminescent (EL) devices or organic light-emitting diodes (OLEDs) are electronic devices that emit light in response to an applied potential. Tang and others. (Applied Physics Letters, 51, 913 (1987), Journal of Applied Physics, 65, 3610 (1989), and commonly assigned US-A-4,769,292) demonstrated highly efficient OLEDs. Since then, numerous OLEDs with alternative layer structures, including polymeric materials, have been disclosed and device performance has been improved. FIG. 1 illustrates schematically the cross-sectional view of a conventional top emitting OLED. Device 101 includes a substrate 10, a reflective bottom-electrode 12, an organic EL element 14, and a transparent top-electrode layer 16. The organic EL element can include one or more sub-layers including a hole injection layer 14a, a hole transport layer 14b, a light emitting layer 14c, an electron transport layer 14d, and an electron injection layer 14e. In FIG. 1 the reflective bottom electrode 12 is the anode and the transparent top-electrode layer 16 is the cathode; but the reverse can also be the case and if so the order of the sub-layers in the organic EL element 14 is reversed.

The luminance output efficiency is an important figure of merit parameter of an OLED device. It determines how much current or power is needed to drive an OLED to deliver a desired level of light output. In addition, since the lifetime of an OLED device is inversely proportional to the operating current, a higher output efficiency OLED device lasts longer at an identical light output level.

A method that potentially can improve luminance output efficiency of an OLED device is to use microcavity effect. OLED devices utilizing microcavity effect (Microcavity OLED devices) have been disclosed in the prior art (US-A-6,406,801 B1; 5,780,174 A1, and JP 11288786 A). In a microcavity OLED device the organic EL element is disposed between two highly reflecting mirrors, one of which is semitransparent. The reflecting mirrors form a Fabry-Perot microcavity that strongly modifies the emission properties of the organic EL disposed in the microcavity. Emission near the wavelength corresponding to the resonance wavelength of the cavity is enhanced through the semitransparent mirror and those with other wavelengths are suppressed. The use of a microcavity in an OLED device has been shown to reduce the emission bandwidth and improve the color purity of emission (US-A-6,326,224). The microcavity also dramatically changes the angular distribution of the emission from an OLED device. There also have been suggestions that the luminance output could be enhanced by the use of a microcavity (Yokoyama, Science, Vol. 256 (1992) p66; Jordan and others Appl. Phys. Lett. 69, (1996) p1997). In most the reported cases, however, at least one of the reflecting mirrors is a Quarter Wave Stack (QWS). A QWS is a multi-layer stack of alternating high index and low index dielectric thin-films, each one a quarter wavelength thick. It can be tuned to have high reflectance, low transmittance, and low absorption over a desired range of wavelength.

FIG. 2 illustrates schematically the cross-sectional view of an exemplary prior art microcavity OLED device 102 based on a QWS. Device 102 includes a substrate 10, a QWS 18 as a semitransparent reflector, a transparent conductive bottom electrode 12, an organic EL element 14, and a reflective top-electrode 16. A typical QWS 18 is of the form $TiO_2:SiO_2:TiO_2:SiO_2:TiO_2$ with $TiO_2$ n = 2.45 and $SiO_2$ n = 1.5 [as in R.H. Jordan and others, APL 69, 1997 (1996)].

The thickness of each material is 56 nm and 92 nm, respectively, corresponding to quarter wavelength for green emission at 550 nm. In operation only a narrow band light centered at the resonance wavelength of 550 nm is emitted through the QWS layer out of the microcavity OLED device. The peak height of the emission can be greatly enhanced over a similar device without the microcavity although the total luminance integrated over the entire visible wavelength range may or may not be increased.

It is generally believed that a QWS constructed of non-absorbing dielectric materials is necessary in achieving useful microcavity effects. Yokoyama and others (Science V256, p 66 (1992) in his well referenced review article specifically recommended the use of QWS instead of metallic mirrors. A QWS, however, is complicated in structure and expensive to fabricate. The resonance bandwidth is extremely narrow and, as a result, even though a microcavity based on a QWS is capable of greatly increasing the emission peak height at the resonance wavelength, the total luminance integrated over the visible wavelength range is much less improved and can actually decrease over a similar device without the microcavity. In addition, the dielectric layers are not electrically conductive. To form an OLED device, a separate transparent conductive electrode layer needs to be disposed between the QWS and the organic layers. This added conductive electrode layer further complicates the structure. If a transparent conductive oxide is used as the conductive electrode, the electrical conductance is limited and can be inadequate for many devices especially those having large areas. If a thin metal film is used, the cavity structure is much more complicated and device performance can be compromised.

Published attempts to replace the QWS with metallic mirrors have not been very successful. Berggrem and others (Synthetic Metals 76 (1996) 121) studied a PLED using an A1 mirror and a Ca-A1 semi-transparent mirror to construct a microcavity. Although some bandwidth narrowing was observed suggesting microcavity effect, the external quantum efficiency of the device with microcavity was a factor of three less than a similar device without microcavity.

Takada and others (Appl. Phys. Lett. 63, 2032 (1993)) constructed a microcavity OLED device using a semi-transparent (36 nm) Ag cathode and a 250 nm MgAg anode. Although angular distribution change and emission bandwidth reduction was observed, the emission intensity was significantly reduced compared with a non-cavity case. The authors concluded that the combination of emission dyes with broad emission spectra and a simple planar cavity was not satisfactory for the confinement of light in the microcavity, and encouraged development of new cavity structures.

Jean el al (Appl. Phys. Lett., Vol 81, (2002) 1717) studied an OLED structure using a 100 nm A1 as the anode and 30 nm A1 as the semitransparent cathode to construct a microcavity structure. Although a strong microcavity-effect caused emission bandwidth narrowing and angular dependence change was observed, no improvement in luminance efficiency was suggested. In fact judging from the extremely narrow emission bandwidth of the devices, the luminance efficiency was most likely decreased.

EP 1,154,676, A1 disclosed an organic EL device having a first electrode of a light reflective material, an organic light emitting layer, a semitransparent reflection layer, and a second electrode of a transparent material forming a cavity structure. The objective was to achieve sufficient color reproduction range over a wide viewing angle. The objective was achieved by reducing the microcavity effect to achieve a large emission bandwidth. Although it was suggested that multiple reflection enhances resonance wavelength emission, no actual or simulated data supported the suggestion. All examples used a Cr reflective anode. As will be shown from the present invention's modeling calculation, little luminance enhancement is expected when a low reflectivity anode such as Cr is used.

Lu and others (Appl. Phys. Lett. 81, 3921 (2002) described top-emitting OLED devices that the authors alleged to have performance enhanced by microcavity effects. However, their performance data showed very little angular dependence characteristic of microcavities. Although no spectral data were shown, the similarity in color coordinates between their bottom emitting structure and top emitting structure suggests that the bandwidth narrowing effect expected in microcavity OLED devices is most likely absent as well. Indeed, our model calculations confirm that their structure should not produce a significant microcavity effect. Thus, the observed emission enhancement is most likely a result of normal modest optical interference effects typically seen in non-microcavity OLED devices. The magnitude of the emission enhancement is very small and the color quality improvement is absent. The authors also suggested that the best efficiency is achieved by using a high reflectivity anode and a transparent cathode, the latter being clearly contrary to the teaching of the present invention.

It is an object of the present invention to provide a microcavity OLED device with improved luminance efficiency and color quality.

It is a further object of the present invention to provide a microcavity OLED device that can be easily fabricated.

It is another object of the present invention to provide a microcavity OLED device with a low internal series resistance to reduce the power loss.

These objects are achieved by providing a microcavity OLED device comprising:

(a) a substrate;
(b) a metallic bottom-electrode layer disposed over one surface of the substrate;
(c) an organic EL element disposed over the metallic bottom-electrode layer; and
(d) a metallic top-electrode layer disposed over the organic EL element,

wherein one of the metallic electrode layers is semitransparent and the other one is essentially opaque and reflective; and wherein the materials for the opaque and reflective metallic electrode layer are selected from Ag, Au, Al, or alloys thereof, the materials for the semitransparent metallic electrode layer are selected from Ag, Au, or alloys thereof, and wherein the thickness of the semitransparent metallic electrode layer and the location of the light emitting layer are selected to enhance the emission output of the microcavity OLED device above that of a similar device without the microcavity.

In another aspect of the present invention, a high-index absorption-reduction layer next to the semitransparent metallic electrode layer outside the microcavity is used to further improve the performance of the microcavity OLED device..

The metallic bottom-electrode layer can be the semitransparent one, in which case the microcavity OLED device in accordance with the present invention is bottom emitting. Alternatively, the metallic top-electrode can be the semitransparent one, in which case the microcavity OLED device in accordance with the present invention is top emitting.

The metallic bottom-electrode can be the anode and the metallic top-electrode can be the cathode. Alternatively, the metallic bottom-electrode can be the cathode and the metallic top-electrode can be the anode. In either case the organic EL element is appropriately orientated so that the hole injecting and hole transport layers are closer to the anode and the electron injecting and electron transport layers are closer to the cathode.

FIG. 1 is a schematic cross-sectional view of a conventional OLED device;

FIG. 2 is a schematic cross-sectional view of a prior art microcavity OLED device based on QWS;
FIG. 3a is a schematic cross-sectional view of a bottom emitting microcavity OLED device according to the present invention using all Ag electrodes;
FIG. 3b is a schematic cross-sectional view of a bottom emitting microcavity OLED device without microcavity;
FIG. 3c is a schematic cross-sectional view of a bottom emitting microcavity OLED device based on QWS;
FIG. 3d is a schematic cross-sectional view of a bottom emitting microcavity OLED with an absorption-reduction layer according to the present invention;
FIG. 4a is a schematic cross-sectional view of a top emitting microcavity OLED device according to the present invention using all Ag electrodes;
FIG. 4b is a schematic cross-sectional view of a top emitting microcavity OLED device without microcavity;
FIG. 4c is a schematic cross-sectional view of a top emitting microcavity OLED device based on QWS;
FIG. 4d is a schematic cross-sectional view of a top emitting microcavity OLED with an absorption-reduction layer according to the present invention; and
FIG. 5 shows the comparison of emission spectra between an OLED device without microcavity and a microcavity OLED device according to the present invention.

The microcavity OLED device in accordance with the present invention has a resonance wavelength determined by the total optical thickness of the layers in between. The emission from the organic EL element out of a microcavity OLED device is enhanced near the resonance wavelength and suppressed elsewhere resulting in a narrowing of the emission bandwidth. The microcavity effect also changes the angular distribution of the emitted light from the OLED device. In a conventional non-microcavity based OLED device, about 80% of the light emitted by the organic EL element is trapped in the organic layers and the substrate. With the microcavity, this trapped light percentage is reduced due to the changed angular distribution, resulting in an enhanced light output from the device. The benefit of enhanced luminance has been reported in microcavity OLED devices based on a QWS, but none of the reported microcavity OLED devices based on all-metallic mirrors have achieved significant luminance enhancement.

In view of the teaching and the unsuccessful attempts of the prior art, it was discovered quite unexpectedly through extensive modeling and experimental efforts that high performance microcavity OLED devices can actually be fabricated using all metallic mirrors. It has been discovered that the material selection for both the reflecting and the semitransparent metallic electrodes is important and the thickness of the semitransparent metallic electrode is also important. Only a small number of metals, including Ag, Au, Al, and alloys thereof, defined as alloys having at least 50 atomic percent of at least one of these metals, are preferably used as the reflective electrode. When other metals are used, the benefits of luminance output increase and color quality improvement due to microcavity effect are much reduced. Similarly, for the semitransparent electrode only a small number of materials including Ag, Au, Al, alloys and alloys thereof are preferably used. The thickness range of the semitransparent electrode is also limited. Too thin a layer does not provide a significant microcavity effect and too thick a layer reduces the luminance output. In addition, the location of the light emitting layer within the microcavity also strongly affects the luminance output and needs to be optimized.

Metallic mirrors are simpler in structure and easier to fabricate than QWS. The use of two metallic mirrors which also function as electrodes eliminates the need for a separate transparent conductive electrode. The sheet conductivity of the semitransparent metallic electrode can be much higher than the transparent conductive electrodes used in the prior art. The increased conductivity reduces Ohmic loss in an OLED device, especially if the device area is large. The emission bandwidth using appropriately designed metallic mirrors are broader than those obtained using QWS and hence the luminance output is increased. On the other hand, the emission bandwidth is still narrow enough to provide excellent color quality.

Since not all the preferred materials for the metallic electrodes provide good charge injection, the organic EL element preferably includes a hole injection layer next to the anode and/or an electron injection layer next to the cathode. Suitable materials for use as the hole-injecting layer include, but are not limited to, porphyrinic compounds as described in commonly-assigned US-A-4,720,432, and plasma-deposited fluorocarbon polymers as described in commonly-assigned US-A-6,208,075. Alternative hole-injecting materials reportedly useful in organic EL devices are described in EP 0 891 121 A1 and EP 1029 909 A1 and by Tokito and others, J. Phys. D. Vol 29 (1996) 2750. Electron injecting layers including those taught in US-A-5,608,287; US-A-5,776,622; US-A-5,776,623; US-A-6,137,223; and US-A-6,140,763 disclosures of which are here incorporated by reference, can be employed. Alkaline metal and alkaline metal doped electron transport materials such as Li or Cs doped Alq can also be used effectively as the electron injecting layer.

In some cases, materials used for the metal electrodes cause instability in the OLED device due to chemical interactions, electro-migration, or other causes. A suitable barrier layer can be used to prevent such instabilities. Again, the presence of a good electron or hole injecting layers allows a wide range of materials options for such a purpose.

The organic EL element has at least one light-emitting layer, but commonly it comprises several layers. An exemplary organic EL element can include a hole injecting layer, a hole transport layer, a light-emitting layer, an electron transport layer, and an electron injecting layer. Some of these layers can be omitted or combined. The organic EL element can be based on small molecule OLED materials, or it can be based on polymer OLED materials. A device based on polymer OLED materials is often referred to as a PLED.

In accordance with the present invention, the thickness of the organic EL element can be varied in order to adjust the microcavity resonance wavelength. In addition, a transparent conductive spacer layer can be used as an additional means to adjust the microcavity resonance wavelength. The transparent conductive spacer layer can be disposed between one of the metallic electrodes and the organic EL element. It needs to be transparent to the emitted light and it needs to be conductive to carry the charge carriers between the metallic electrode and the organic EL element. Since only through-film conductance is important, a bulk resistivity of less than about $10^8$ ohm-cm is adequate. Many metal oxides such as, but not limited to, indium-tin oxide (ITO), zinc-tin oxide (ZTO), tin-oxide(SnOx), indium oxide (InOx), molybdnum oxide (MoOx), tellurium oxide (TeOx), antimony oxide (SbOx), and zinc oxide (ZnOx), can be used.

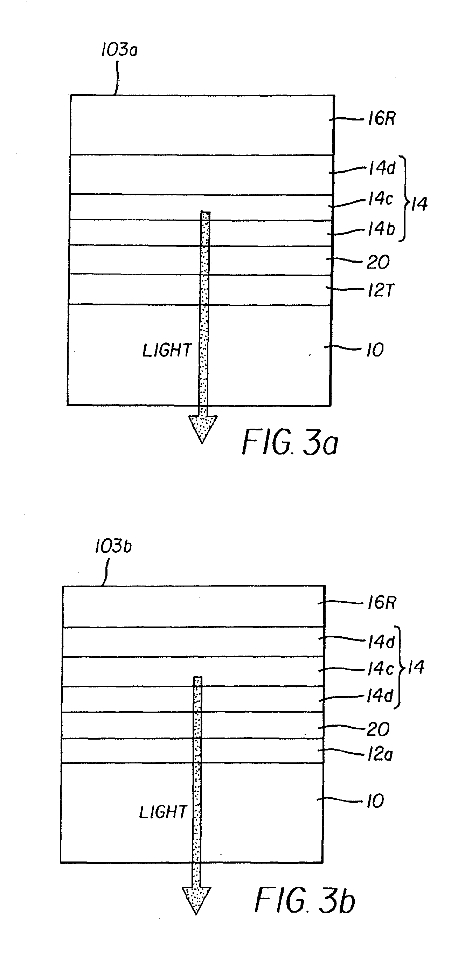

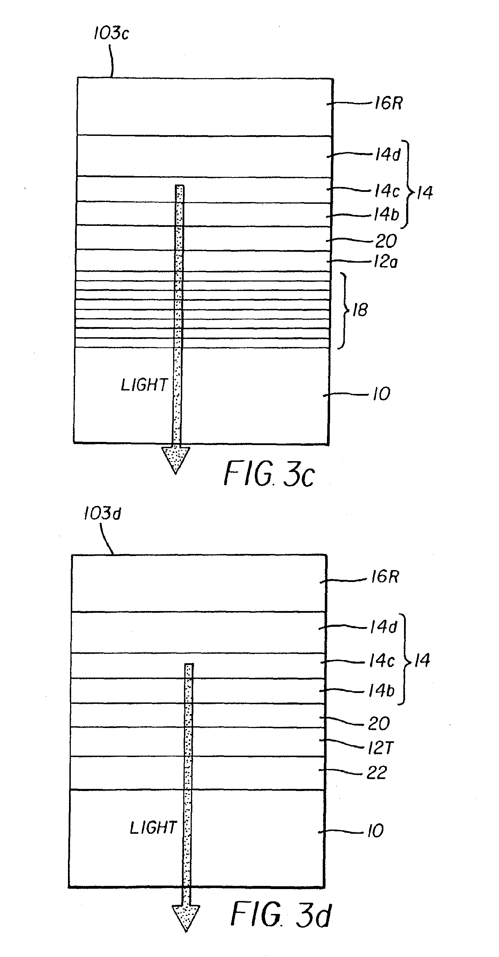

FIG. 3 a illustrates schematically the cross-sectional view of a bottom emitting microcavity OLED device 103a according to the present invention. Microcavity OLED device 103a includes a substrate 10, a semitransparent metallic bottom anode 12T (layer), a transparent conductive spacer layer 20, an organic EL element 14, and a reflective metallic top cathode 16R. The two metallic electrodes function as the reflective mirrors of the microcavity. Since the generated light emits through the semitransparent metallic bottom anode 12T and the substrate 10, substrate 10 needs to be transparent, and can be selected from glass or plastic. Reflective metallic top cathode 16R and semitransparent metallic bottom anode 12T are both selected from Ag, Au, Al or alloys thereof. The thickness of the reflective metallic top cathode 16R is selected to have an optical density over 1.5 or larger so that it is essentially opaque and reflective. The thickness of the semitransparent metallic bottom anode 12T is selected to optimize the luminance light output at a predetermined wavelength from the microcavity OLED device 103a. The preferred thickness depends on the materials selected to be the anode and the cathode. An organic EL element 14 includes at least a light emitting layer 14c, and may include one or more additional layer such as hole injecting layer 14a (not shown), hole transport layer 14b, electron transport layer 14d, and electron injection layer 14e (not shown). A detailed description of these layers is set forth later. The combined thickness of the organic EL element 14 is selected to tune the microcavity OLED device 103 a to have the resonance at the predetermined wavelength to be emitted from the device. The thickness satisfies the following equation:

$$2 \, \Sigma \, n_i L_i + 2 \, n_s L_s + (Q_{m1} + Q_{m2}) \, \lambda/2\pi = m\lambda \qquad \text{Eq. 1}$$

wherein $n_i$ is the refractive index and $L_i$ is the thickness of the nth sub-layer in organic EL element 14; $n_s$ is the refractive index and $L_s$ is the thickness, which can be zero, of the transparent conductive spacer layer 20; $Q_{m1}$ and $Q_{m2}$ are the phase shifts in radians at the two organic EL element-metal electrode interfaces, respectively; $\lambda$ is the predetermined wavelength to be emitted from the device, and m is a non-negative integer. It is preferred to have m as small as practical, typically less than 2.

The total thickness between the metal electrodes is the most important factor in determining the microcavity resonance wavelength. However, the resonance wavelength and more particularly the strength of the resonance (and thus the resulting efficiency of the device) also depend on the distance between the emitting layer and each of the two electrodes. In particular, for optimal device performance, the distance between the reflective metallic top cathode 16R and (the center of) the emitting layer should roughly satisfy the following equation:

$$2 \, \Sigma \, n_i L_i + Q_{m1} \, \lambda/2\pi = m_D \, \lambda \qquad \text{Eq. 2}$$

wherein $n_i$ is the refractive index and $L_i$ is the thickness of the nth sub-layer in organic EL element 14, $Q_{m1}$ is the phase shift in radians at the organic EL element-metal cathode interface, $\lambda$ is the predetermined wavelength to be emitted from the device, and $m_D$ a non-negative integer. Note that, in contrast to Eq. 1, the sum here is only over those layers that lie between (the center of) the emitting layer and the reflective metallic top cathode 16R. The thickness of the transparent conductive spacer layer 20 should be included if it is disposed between the metallic electrodes. One could write an analogous equation for the distance between the semitransparent metallic bottom anode 12T and the emitting layer. However, since satisfaction of Eqs. 1 and 2 guarantee the satisfaction of this third equation, it does not provide any additional constraint.

Since it is desirable that the absorption of light by the semitransparent metallic bottom anode 12T be as low as feasible, a useful addition (that will be illustrated further in the examples below) is an absorption-reduction layer 22 between the semitransparent metallic bottom anode 12T and the substrate 10. The purpose of this layer is to reduce the electric field produced by the light wave (and thus the absorption of the light wave) within the semitransparent metallic bottom anode 12T itself. To a good approximation, this result is best accomplished by having the electric field of the light wave reflected back from the interface between this absorption-reduction layer 22 and the substrate 10 interfere destructively with, and thus partly cancel, the electric field of the light passing out of the device. Elementary optical considerations then imply that this will occur (for an absorption-reduction layer having a higher refractive index than the substrate) when the following equation is approximately satisfied:

$$2n_A L_A + n_T L_T = (m_A + 1/2)\lambda \hspace{3cm} \text{Eq. 3}$$

where $n_A$ and $L_A$ are the refractive index and the thickness of the absorption-reduction layer respectively, $n_T$ and $L_T$ are the real part of the refractive index and the thickness of the semitransparent metal bottom anode respectively, and $m_A$ is a non-negative integer. It is preferred to have $m_A$ as small as practical, usually 0 and typically less than 2. In an alternate configuration of the device, the semitransparent metallic bottom anode 12T can be the cathode and the metallic top electrode 16R can be the anode. In such a case the organic EL element 14 is appropriately orientated so that the hole injecting and hole transport layers are closer to the anode and the electron injecting and electron transport layers are closer to the cathode.

The effectiveness of the present invention in utilizing the microcavity to enhance the OLED device output is illustrated in the following examples. In the examples based on theoretical prediction, the electroluminescence (EL) spectrum produced by a given device is predicted using an optical model that solves Maxwell's Equations for emitting dipoles of random orientation in a planar multilayer device {O. H. Crawford, J. Chem. Phys. 89, 6017 (1988); K. B. Kahen, Appl. Phys. Lett. 78, 1649 (2001)}. The dipole emission spectrum is assumed to be independent of wavelength in many cases so that the microcavity property itself can be investigated. In other cases the dipole emission spectrum is assumed to be given by the measured photoluminescence (PL) spectrum of the emitter material, incorporating a small blue shift of a few nanometers. This emission is assumed to occur uniformly in the first 10 nm of the emitting layer bordering the hole transport layer. For each layer, the model uses wavelength-dependent complex refractive indices that are either measured by spectroscopic ellipsometry or taken from the literature {Handbook of Optical Constants of Solids, ed. by E. D. Palik (Academic Press, 1985); Handbook of Optical Constants of Solids II, ed. by E. D. Palik (Academic Press, 1991); CRC Handbook of Chemistry and Physics, 83rd ed., edited by D. R. Lide (CRC Press, Boca Raton, 2002)}. Once the EL spectrum has been derived, it is straightforward to compute the luminance (up to a constant factor) and the CIE chromaticities of this spectrum. Numerous comparisons between predicted EL spectra and measured EL spectra have confirmed that the model predictions are very accurate.

**Example 1**

Example 1 compares the theoretically predicted luminance output of a bottom emitting microcavity OLED device 103a as shown in FIG. 3a in accordance with the present invention against two comparative devices:

    (a) an OLED device 103b without a microcavity, and
    (b) a microcavity OLED device 103c using QWS as one of the mirrors for the microcavity.

OLED device 103b shown in FIG. 3b was similar in construction to microcavity OLED device 103a except that the semitransparent metallic bottom anode 12T is an Ag anode was replaced by a transparent conductive ITO anode 12a. This device represents an OLED device without microcavity, although there is always some optical interference effect in a multi-layer device.

Microcavity OLED device 103c shown in FIG 3c was similar in construction to OLED device 103b except that a QWS reflecting mirror 18 was disposed between substrate 10 and transparent conductive ITO anode 12a. The QWS reflecting mirror 18 was of the form $TiO_2:SiO_2:TiO_2:SiO_2:TiO_2$ with $TiO_2$ n = 2.45 and $SiO_2$ n = 1.5. Thickness of each materials was 56 nm for $TiO_2$ and 92 nm for $SiO_2$ {as in R.H. Jordan and others, APL 69, 1997 (1996)}. This device represents a typical QWS based microcavity OLED device.

For all three devices substrate 10 was glass. Reflective metallic top cathode 16R was a 400 nm Ag layer. The organic EL element 14 was assumed to include a NPB hole transport layer 14b, a 10 nm light-emitting layer 14c, and an Alq electron transport layer 14d. The light emitting layer 14c was assumed to have an output that is independent of wavelength. This assumption was to facilitate the evaluation of the microcavity property itself independent of the specific properties of emitter so that the conclusion can be applied generically to any emitters. The use of a wavelength-independent emitter, however, under-estimates the beneficial effect of microcavity. The thickness of the transparent conductive spacer layer 20 was assumed to be zero for all three devices.

The thickness of all the layers was optimized to achieve maximum luminance output from each device. The luminance output was integrated over the entire visible wavelength range from 380 nm to 780 nm.

The calculated results are summarized in Table 1. These results showed that microcavity OLED device 103c using QWS as a semitransparent mirror indeed enhanced the luminance output and narrowed the emission bandwidth (full-width-half-max FWHM) when compared with OLED device 103b without the microcavity. The luminance value improved from 0.239 (arbitrary units) to 0.385. Microcavity OLED device 103 a using all Ag mirrors, however, showed surprisingly better luminance output, 0.425, even though the peak luminance height was more than a factor of two lower than that of microcavity OLED device 103c. The emission bandwidth of the all-Ag microcavity OLED device 103a was much larger than OLED device 103c with QWS, but it was still small enough to yield good color purity.

**TABLE 1**

| Device | Description | Substrate | QWS | Anode (ITO) nm | Anode (Ag) nm | NPB nm | Flat Band Emitter nm | Alq nm | Cathode (Ag) nm | Luminance arbitrary | Peak location nm | Peak height arbitrary | FWHM nm |
|---|---|---|---|---|---|---|---|---|---|---|---|---|---|
| 103a | no cavity | Glass | | 100.7 | | 43.1 | 10 | 63.1 | 400 | 0.239 | 547 | 2.4 | N.A. |
| 103b | QWS, | Glass | yes | 50.0 | | 26.6 | 10 | 64.9 | 400 | 0.385 | 564 | 16.8 | 17.0 |
| 103 | all Ag | Glass | | | 17.5 | 45.9 | 10 | 64.3 | 400 | 0.425 | 567 | 6.6 | 73.0 |

**Example 2**

Example 2 is a demonstration of the benefit of the absorption-reduction layer 22.

FIG. 3d illustrates schematically the cross-sectional view of a bottom emitting microcavity OLED device 103d.

Microcavity OLED device 103d was similar in structure to microcavity OLED device 103a except an absorption-reduction layer 20 was disposed between substrate 10 and semitransparent metallic bottom anode 12T. For this example, ITO was selected as the absorption-reduction layer 22. Our calculations showed that the effectiveness of the absorption-reduction layer 22 in enhancing luminance output would improve if a higher refractive index material was used. As will be apparent from Example 4, luminance output could also be increased if the absorption-reduction layer 22 were in direct contact with air rather than with glass. The thickness of all layers was optimized as in Example 1. The results of the calculation are summarized in Table 2. It can be seen that the insertion of absorption-reduction layer 22 increased the luminance output of the all Ag microcavity OLED device 103a from about 0.425 to about 0.453.

**TABLE 2**

| Device | Description | Substrate | Absorption-reduction (ITO) nm | Anode (Ag) nm | NPB nm | Flat Band Emitter nm | Alq nm | Cathode (Ag) nm | Luminance arbitrary | Peak Location nm | Height arbitrary | FWHM nm |
|---|---|---|---|---|---|---|---|---|---|---|---|---|
| 103a | Without absorption-reduction | Glass | | 17.5 | 45.9 | 10 | 64.3 | 400 | 0.425 | 567 | 6.6 | 73 |
| 103d | With absorption-reduction | Glass | 82.2 | 18.5 | 48.1 | 10 | 64.3 | 400 | 0.453 | 565 | 7.0 | 75 |

**Example 3**

Example 3 compares the theoretically predicted luminance output of a top emitting microcavity OLED device 104a in accordance with the present invention against two comparative devices:

(a) an OLED device 104b without a microcavity, and
(b) a microcavity OLED device 104c using a QWS as one of the reflecting mirrors for the microcavity.

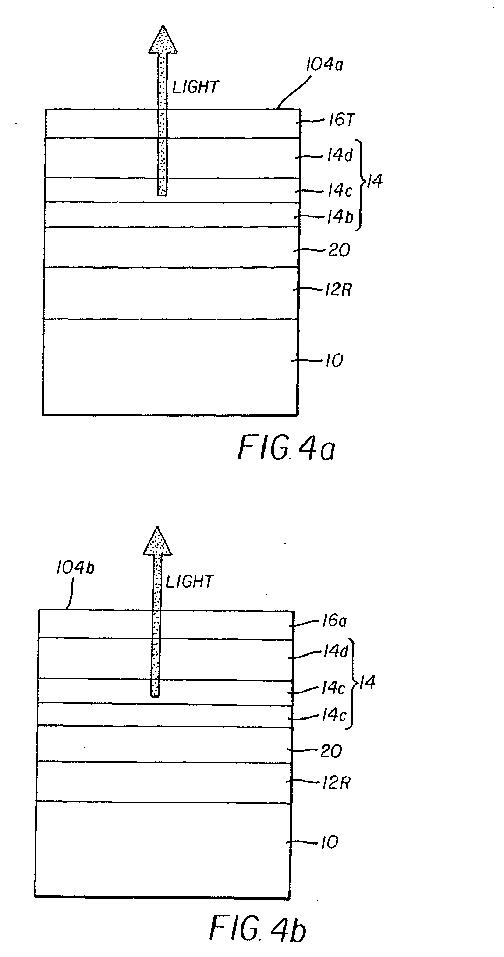

FIG. 4a illustrates schematically the cross-sectional view of an exemplary top emitting microcavity OLED device 104a according to the present invention. Microcavity OLED device 104a included a glass substrate 10, a reflective Ag anode 12R, a transparent conductive spacer layer 20, an organic EL element 14, and a semitransparent Ag cathode 16T.

OLED device 104b shown in FIG 4b was similar in construction to microcavity OLED device 104a except that the semitransparent Ag cathode 16T was replaced by a transparent conductive ITO cathode 16a which was required to have a thickness of at least 50 nm. Because there was only one reflecting mirrors in the device, OLED device 104b represents an OLED device without a microcavity, although there is always some optical interference effect in a multi-layer device, particularly at the interface between the ITO cathode and the air.

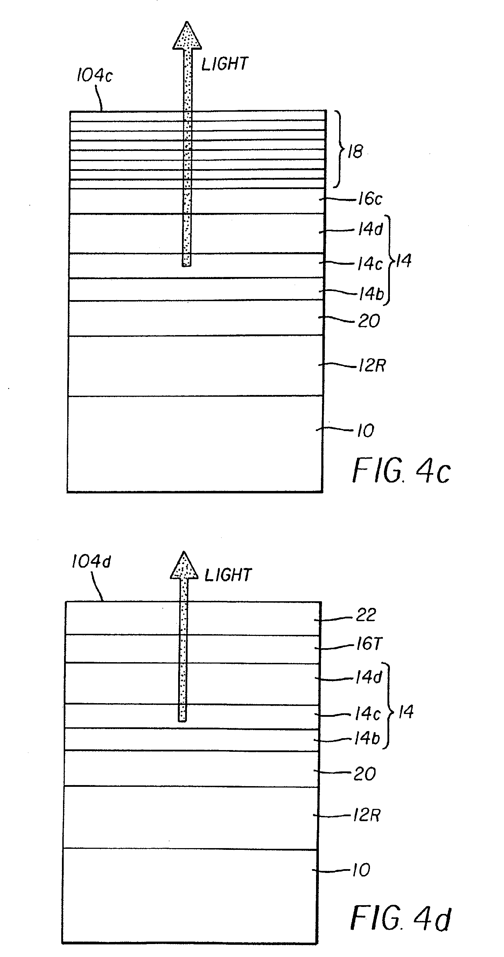

OLED device 104c shown in FIG. 4c was similar in construction to OLED device 104b except that a QWS reflecting mirror 18 was disposed on top of transparent conductive ITO cathode 16a which was required to have a thickness of at least 50 nm. The QWS reflecting mirror 18 was of the form $TiO_2:SiO_2:TiO_2:SiO_2:TiO_2$ with $TiO_2$ n = 2.45 and $SiO_2$ n = 1.5. Thickness of each materials is 56 nm for $TiO_2$ and 92 nm for $SiO_2$ {as in R.H. Jordan and others., APL 69, 1997 (1996)}. This device represents a typical QWS based microcavity OLED device.

For all three devices the reflective anode layer 12R was a 400 nm Ag layer. The organic EL element 14 was assumed to include a NPB hole transport layer 14b, a 10 nm light-emitting layer 14c, and an Alq electron transport layer 14d. The light emitting layer 14c was assumed to have an output that was independent of wavelength. This assumption is to facilitate the evaluation of the microcavity property itself independent of the specific properties of emitter so that the conclusion can be applied generically to any emitters. The transparent conductive spacer layer 20 was made of ITO. The thickness of all the layers was optimized to achieve maximum luminance output from each device. The luminance output was integrated over the entire visible wavelength range from 380 nm to 780 nm.

TABLE 3

| Device | Anode | ITO | NPB | Flat Band Emitter | Alq | cathode | cathode | Luminance | Peak Location | Peak Ht. | FWHM |
|---|---|---|---|---|---|---|---|---|---|---|---|
| | Ag | nm | nm | nm | nm | material | nm | Arbitrary | nm | Arbitrary | nm |
| 104c | 400 | 19.7 | 30 | 10 | 77.0 | ITO | 86.8 | 0.318 | 555 | 3.8 | 141 |
| 104b | 400 | 23.1 | 30 | 10 | 39.8 | ITO+QWS | 50 | 0.335 | 563 | 18.9 | 13 |
| 104a | 400 | 20.2 | 30 | 10 | 44.6 | Ag | 13.7 | 0.411 | 568 | 6.2 | 75 |

Table 3 shows the calculated characteristics of the three devices. Microcavity OLED device 104c using a QWS as one of its reflecting mirrors did show a very strong microcavity effect. The luminance peak height was greatly increased to 18.9 (arbitrary units) as compared with a value of 3.4 for OLED device 104b without microcavity. Because of the much narrowed FWHM, however, the total luminance output was actually only modestly larger. If the minimum thickness of the ITO cathode were set to a larger value than 50 nm (say, 100 nm) in order to obtain the required electrical conductivity for the cathode, then the QWS is actually found to have a lower luminance than the device without the QWS because the cavity thickness for the QWS case cannot be optimized at the lowest order maximum. Microcavity OLED device 104a using Ag for both electrodes, on the other hand, showed a significant improvement in luminance output over the other two comparative devices.

**Example 4**

Example 4 is a demonstration of the benefit of the absorption-reduction layer.

FIG. 4d illustrates schematically the cross-sectional view of a top emitting microcavity OLED device 104d. Microcavity OLED device 104d was similar in structure to microcavity OLED device 104a except that an absorption-reduction layer 22 was disposed over semitransparent cathode layer 16T. For this example, ZnS:20%$SiO_2$ was selected as the exemplary absorption-reduction layer 22. Our calculations showed that the effectiveness of the absorption-reduction layer in enhancing luminance output would improve if a higher refractive index material was used. The thickness of all layers was optimized for luminance output. The results of the calculation are summarized in Table 4. It can be seen that the insertion of absorption-reduction layer 22 increased the luminance output of the microcavity OLED device from about 0.411 to about 0.500.

TABLE 4

| Device | Anode | ITO | NPB | Alq | cathode cathode | | ZnS:Si02 | Luminance | Peak Location | Peak Ht. | FWHM |
|--------|-------|-----|-----|-----|---------|-----|----------|-----------|---------------|----------|------|
|        | Ag    | nm  | nm  | nm  | material | nm  | nm       | Arbitrary | nm            | Arbitrary | nm  |
| 104a   | 400   | 20.2 | 30 | 44.6 | Ag      | 13.7 | 0        | 0.411     | 568           | 6.2      | 75   |
| 104d   | 400   | 19.6 | 30 | 58.3 | Ag      | 20.3 | 61.4     | 0.504     | 560           | 9        | 58   |

**Example 5**

Example 5 compares different materials for use as the reflective metallic electrode layer.

Table 5 shows the calculated luminance output of devices made according to FIG. 4d but using different materials for the reflective metallic bottom anode 12R. For all devices the semitransparent cathode layer 16T was a thin Ag layer. The organic EL element 14 was assumed to include a NPB hole transport layer 14b, a 10 nm light-emitting layer 14c, and an Alq electron transport layer 14d. The light emitting layer was assumed to have an output that was independent of wavelength. This assumption is to facilitate the evaluation of the microcavity property itself independent of the specific properties of emitter so that the conclusion can be applied generically to any emitters. An ITO layer was used as the transparent conductive spacer layer 20 and a $ZnS:(20\%)SiO_2$ dielectric layer was used as the absorption-reduction layer 22. The thickness of all layers, except that of the NPB hole transport layer 14b, was optimized to give maximum luminance output. The thickness of the hole transport layer 14b was fixed at 30 nm for all devices.

**TABLE 5**

| Anode | ITO | NPB | Emitter | Alq | cathode material | cathode | ZnS:SiO2 | Luminance | Peak λ | Peak Ht. | FWHM |
|---|---|---|---|---|---|---|---|---|---|---|---|
| | nm | nm | nm | nm | material | nm | nm | Arbitrary | nm | Arbitrary | nm |
| Ag | 19.6 | 30 | 10 | 58.3 | Ag | 20.3 | 61.4 | 0.504 | 560 | 9 | 58 |
| Al | 29.4 | 30 | 10 | 58.0 | Ag | 19.7 | 60.8 | 0.481 | 558 | 8 | 63 |
| Au | 16.2 | 30 | 10 | 60.8 | Ag | 19.0 | 63.8 | 0.435 | 558 | 7.7 | 70 |
| MgAg | 23.7 | 30 | 10 | 56.1 | Ag | 15.7 | 65.8 | 0.429 | 558 | 6.7 | 72 |
| Cu | 16.5 | 30 | 10 | 63.5 | Ag | 14.5 | 62.3 | 0.310 | 593 | 4.9 | 96 |
| Cr | 29.2 | 30 | 10 | 62.7 | Ag | 10 | 60.6 | 0.239 | 555 | 2.8 | 160 |
| Mo | 29.8 | 30 | 10 | 71.8 | Ag | 0 | 71.3 | 0.199 | 565 | 2.2 | 186 |
| Zr | 7.9 | 30 | 10 | 10.0 | Ag | 0 | 0 | 0.096 | 588 | 0.9 | |

Table 5 shows the calculated characteristics of devices made using different reflective anode materials. The selection of anode material had a drastic effect on the luminance efficiency of the devices. There appears to be a direct correlation between the reflectivity of the anode material and the luminance output. There was over a factor of five difference in luminance output between the lowest reflectivity Zr anode and the highest reflectivity Ag anode. For the lowest reflectivity anodes such as Mo or Zr, the optimum luminance was obtained when there was no semitransparent cathode. The FWHM was very large and there was little luminance enhancement due to the microcavity unless Ag, Al, Au and MgAg was used as the anode.

**Example 6**

Example 6 demonstrates the effect of cathode materials on device performance.

Table 6A shows the calculated luminance output of devices made according to FIG. 4 but using different materials for the semitransparent metallic top anode 12R. For all devices the reflective anode layer 12R was a 400 nm Ag layer. The organic EL element 14 was assumed to include a NPB hole transport layer 14b, a 10 nm light-emitting layer 14c, and an Alq electron transport layer 14d. The light emitting layer was assumed to have an output that was independent of wavelength. This assumption is to facilitate the evaluation of the microcavity property itself independent of the specific properties of emitter so that the conclusion can be applied generically to any emitters. An ITO layer was used as the transparent conductive spacer layer 20 and no absorption-reduction layer 22 was used. The thickness of all layers, except that of the NPB hole transport layer 14b, was optimized to give maximum luminance output. The thickness of the hole transport layer 14b was fixed at 30 nm for all devices and the thickness of electron transport layer 14d was restricted to be 20 nm or larger. Without the latter restriction the optimization algorithm selects an unrealistically small thickness for the electron transport layer..

**TABLE 6A**

| Anode | ITO Absorption Reduction Layer | NPB Thickness | Emitter Thickness | Alq Thickness | Cathode | Cathode Thickness | Luminance | Peak Wavelength | Peak Height | FWHM |
|---|---|---|---|---|---|---|---|---|---|---|
| | nm | nm | nm | nm | | nm | a. u. | nm | a. u. | nm |
| Ag | 20.2 | 30 | 10 | 54.6 | Ag | 13.7 | 0.411 | 567.5 | 6.2 | 75 |
| Ag | 21.5 | 30 | 10 | 54.5 | Au | 21.3 | 0.385 | 582.5 | 5.9 | 94 |
| Ag | 11.4 | 30 | 10 | 20.0 | MgAg | 0 | 0.345 | 567.5 | 3.4 | N.A. |
| Ag | 11.4 | 30 | 10 | 20.0 | Al | 0 | 0.345 | 567.5 | 3.4 | N.A. |
| Ag | 11.4 | 30 | 10 | 20.0 | Cu | 0 | 0.345 | 567.5 | 3.4 | N.A. |
| Ag | 11.4 | 30 | 10 | 20.0 | Cr | 0 | 0.345 | 567.5 | 3.4 | N.A. |
| Ag | 11.4 | 30 | 10 | 20.0 | Mo | 0 | 0.345 | 567.5 | 3.4 | N.A. |
| Ag | 11.4 | 30 | 10 | 20.0 | Zr | 0 | 0.345 | 567.5 | 3.4 | N.A. |

Table 6A shows that the selection of material for the semitransparent cathode 16T had a significant impact on device performance. Only devices using Au and Ag as the semitransparent cathode 16T showed microcavity enhancement effect. Using all other materials as cathode, the optimum performance was obtained when no cathode thickness was used. Of course this not a realistic case since a cathode is needed to complete the cell.

When an absorption reduction layer is used, more materials can be used as the semitransparent cathode 16T. Table 6B shows the calculated luminance output of devices made similar to those for Table 6A, but with an absorption-reduction layer 22 of $ZnS:(20\%)SiO_2$ added over the semitransparent cathode 16T. For all devices the reflective anode layer 12R was a 400 nm Ag layer. The organic EL element 14 was assumed to include a NPB hole transport layer 14b, a 10 nm light-emitting layer 14c, and an Alq electron transport layer 14d. The light emitting layer was assumed to have an output that was independent of wavelength. This assumption is to facilitate the evaluation of the microcavity property itself independent of the specific properties of emitter so that the conclusion can be applied generically to any emitters. An ITO layer was used as the transparent conductive spacer layer 20 and a $ZnS:(20\%)SiO_2$ dielectric layer was used as the absorption-reduction layer 22. The thickness of all layers, except that of the NPB hole transport layer 14b, was optimized to give maximum luminance output. The thickness of the hole transport layer 14b was fixed at 30 nm for all devices.

**TABLE 6B**

| Anode | ITO | NPB | Emitter | Alq | cathode | | ZnS:SiO2 | Luminance | Peak λ | Peak Ht. | FWHM |
|---|---|---|---|---|---|---|---|---|---|---|---|
| | nm | nm | nm | nm | material | nm | nm | Arbitrary | nm | Arbitrary | nm |
| Ag | 19.6 | 30 | 10 | 58.3 | Ag | 20.3 | 61.4 | 0.504 | 560 | 9 | 58 |
| Ag | 19.9 | 30 | 10 | 56.5 | Au | 21.5 | 62.7 | 0.486 | 565 | 8.3 | 62 |
| Ag | 20.4 | 30 | 10 | 60.1 | MgAg | 12.3 | 67.2 | 0.470 | 558 | 7.3 | 66 |
| Ag | 19.5 | 30 | 10 | 65.0 | Al | 5.5 | 69.1 | 0.440 | 558 | 7.3 | 63 |
| Ag | 18.9 | 30 | 10 | 63.8 | Cu | 14.7 | 64.0 | 0.418 | 565 | 5.9 | 95 |
| Ag | 19.6 | 30 | 10 | 77.3 | Cr | 0 | 64.9 | 0.396 | 560 | 5.3 | 101 |
| Ag | 19.6 | 30 | 10 | 77.3 | Mo | 0 | 64.9 | 0.396 | 560 | 5.3 | 101 |
| Ag | 19.6 | 30 | 10 | 77.3 | Zr | 0 | 64.9 | 0.396 | 560 | 5.3 | 101 |
| Ag | 23.1 | 30 | 10 | 39.8 | ITO+QWS | 50.0 | | 0.335 | 568 | 19.4 | 13 |

Table 6B shows that the selection of material for the semitransparent cathode 16T had a significant impact on device performance. Again the higher reflectivity metals such as Ag, Au, MgAg, and Al showed the best results, but the correlation with reflectivity is not as strong since the higher reflectivity Al gave worst results than Au and MgAg. (This is understood to be due to the fact that the optical absorbance of the metal is also an important parameter for the semitransparent electrode. Al has a particularly large imaginary part of its refractive index and thus a high absorbance.) Also included in the study was a microcavity OLED device using a QWS as the semitransparent mirror. It actually yielded lower total luminance than all other materials investigated. The peak height was significantly higher than all other materials, but because of its extremely small FWHM, the luminance output was the smallest.

**Example 7a (Conventional OLED - comparative):**

The preparation of a conventional non-microcavity OLED is as follows: A 1mm thick glass substrate coated with a transparent ITO conductive layer was cleaned and dried using a commercial glass scrubber tool. The thickness of ITO is about 42 nm and the sheet resistance of the ITO is about 68 $\Omega$/square. The ITO surface was subsequently treated with oxidative plasma to condition the surface as an anode. A 1 nm thick layer of CFx, polymerized fluorocarbon, was deposited on the clean ITO surface as the hole-injecting layer by decomposing $CHF_3$ gas in RF plasma treatment chamber. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole transport layer, 65 nm thick, consisting of N,N'-di(naphthalene-1-yl) -N,N'-diphenyl-benzidine (NPB);
(2) an electron transport layer (also serving as the emissive layer), 75 nm thick, consisting of tris(8-hydroxyquinoline)aluminum(III) (Alq);
(3) an electron injection layer, 1 nm thick, consisting of Li; and
(4) a cathode, approximately 50 nm thick, consisting of Ag.

After the deposition of these layers, the device was transferred from the deposition chamber into a dry box for encapsulation. The completed device structure is denoted as Glass/ITO/CFx/NPB(65)/Alq(75)/Li/Ag.

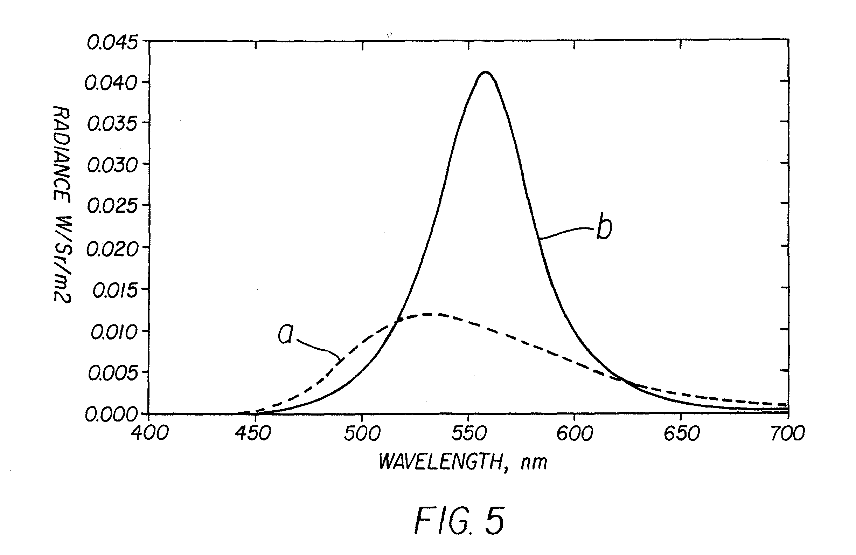

This bottom emitting device requires a driving voltage of 7.1 V to pass 20 mA/cm$^2$, its luminance efficiency is 3.2 cd/A, the FWHM bandwidth is 108 nm, and the color coordinates are CIE-x = 0.352, CIE-y = 0.550. The emission spectrum at 20 mA/cm$^2$ is shown as curve a in FIG. 5.

**Example 7 (inventive):**

A microcavity OLED was fabricated as follows. A glass substrate was coated with an anode layer, 72 nm thick, consisting of Ag, by a DC sputtering process at an Ar pressure of about 4 mTorr. A 1 nm thick layer of CFx, polymerized fluorocarbon, was deposited on the clean Ag surface as the hole-injecting layer by decomposing $CHF_3$ gas in RF plasma treatment chamber. The following layers were deposited in the following sequence by sublimation from a heated boat under a vacuum of approximately $10^{-6}$ Torr:

(1) a hole transport layer, 45 nm thick, consisting of N,N'-di(naphthalene-1-yl) -N,N'-diphenyl-benzidine (NPB);
(2) an electron transport layer (also serving as the emissive layer), 65 nm thick, consisting of tris(8-hydroxyquinoline)aluminum(III) (Alq);
(3) an electron injection layer, 1 nm thick, consisting of Li;
(4) a cathode, approximately 15 nm thick, consisting of Ag; and
(5) an absorption reduction layer, approximately 85 nm thick, consisting of Alq.

After the deposition of these layers, the device was transferred from the deposition chamber into a dry box for encapsulation. The completed device structure is denoted as Glass/Ag/CFx/NPB(45)/Alq(65)/Li/Ag/Alq.

This top emitting device requires a driving voltage of 6.9 V to pass 20 mA/cm$^2$, its luminance efficiency is 8.3 cd/A, the FWHM bandwidth is 56 nm, and the color coordinates are CIE-x = 0.344, CIE-y = 0.617. The emission spectrum at 20 mA/cm$^2$ is shown as curve b in FIG. 5. Compared with the results of comparative Example 7a, the microcavity device according to the present invention showed a significant improvement in luminance output, a reduction in FWHM bandwidth, and a significant improvement in color.

Finally, it is instructive to compare this experimental result with the theoretical prediction obtained from the optical model used to create Examples 1 through 6. The actual gain in luminance output by a factor of 2.6 seen in this example is in excellent agreement with the predicted factor of 2.57 that is obtained from optical modeling of these two structures. The change in the FWHM bandwidth and the change in the CIE color coordinates between these two structures is also predicted with a fair degree of accuracy by the optical model.

**Claims**

1.   A microcavity OLED device comprising:

(a) a substrate;
(b) a metallic bottom-electrode layer disposed over one surface of the substrate;

(c) an organic EL element disposed over the metallic bottom-electrode layer; and

(d) a metallic top-electrode layer disposed over the organic EL element,

wherein one of the metallic electrode layers is semitransparent and the other one is essentially opaque and reflective; and wherein the materials for the opaque and reflective metallic electrode layer are selected from Ag, Au, Al, or alloys thereof, the materials for the semitransparent metallic electrode layer are selected from Ag, Au, or alloys thereof, and wherein the thickness of the semitransparent metallic electrode layer and the location of the light emitting layer are selected to enhance the emission output of the microcavity OLED device above that of a similar device without the microcavity.

2. The microcavity OLED device according to claim 1 wherein both of the metallic electrode layers are Ag and the thickness of the semitransparent electrode layer is between 10 nm and 30 nm.

3. The microcavity OLED device according to claim 1 wherein the metallic bottom-electrode layer is semitransparent and the light is emitted through the substrate.

4. The microcavity OLED device according to claim 3 wherein the device further includes a high index absorption-reduction layer disposed between the semitransparent metallic bottom-electrode layer and the substrate.

5. The microcavity OLED device according to claim 4 wherein the absorption-reduction layer has an index of refraction greater than 1.6.

6. The microcavity OLED device according to claim 3 wherein the device further includes a transparent conductive spacer layer disposed between the semitransparent metallic bottom-electrode layer and the organic EL element or between the organic EL element and the metallic top-electrode layer.

7. The microcavity OLED device according to claim 4 wherein the thickness of the absorption-reduction layer approximately satisfies the equation

$$2n_A L_A + n_T L_T = (m_A + 1/2)\, \lambda$$

where $n_A$ and $L_A$ are the refractive index and the thickness of the absorption-reduction layer respectively, $n_T$ and $L_T$ are the real part of the refractive index and the thickness of the semitransparent metal electrode respectively, and $m_A$ is a non-negative integer. It is preferred to have $m_A$ as small as practical, usually 0 and typically less than 2.

8. The microcavity OLED device according to claim 1 wherein the metallic top-electrode layer is semitransparent and the light is emitted through the semitransparent metallic top-electrode layer.

9. The microcavity OLED device according to claim 8 wherein the device further includes a high index absorption-reduction layer disposed over the semitransparent top-electrode layer.

10. The microcavity OLED device according to claim 9 wherein the absorption-reduction layer has an index of refraction greater than 1.6.

11. The microcavity OLED device according to claim 8 wherein the thickness of the absorption-reduction layer approximately satisfies the equation

$$2n_A L_A + n_T L_T = (mA + 1/2)\, \lambda$$

where $n_A$ and $L_A$ are the refractive index and the thickness of the absorption-reduction layer respectively, $n_T$ and $L_T$ are the real part of the refractive index and the thickness of the semitransparent metal electrode respectively, and $m_A$ is a non-negative integer. It is preferred to have $m_A$ as small as practical, usually 0 and typically less than 2.

12. The microcavity OLED device according to claim 8 wherein the device further includes a transparent conductive spacer layer disposed between the reflective metallic bottom-electrode layer and the organic EL element or between the organic EL element and the metallic top-electrode layer.

13. The microcavity OLED device according to claim 1 wherein the bottom-electrode layer is the anode and the top-electrode layer is the cathode.

14. The microcavity OLED device according to claim 1 wherein the bottom-electrode layer is the cathode and the top-electrode layer is the anode.

101

16R

14d ⎫
14c ⎬ 14
14b ⎭

12T

10

LIGHT

## FIG. 1

102

16R

14d ⎫
14c ⎬ 14
14b ⎭

12a

18

10

LIGHT

## FIG. 2

103a

16R

14d
14c    } 14
14b

20

12T

10

LIGHT

*FIG. 3a*

103b

16R

14d
14c    } 14
14d

20

12a

10

LIGHT

*FIG. 3b*

FIG. 3c

FIG. 3d

*FIG. 4a*

*FIG. 4b*

FIG. 4c

FIG. 4d

FIG. 5